(19) Europäisches Patentamt
European Patent Office
Office européen des brevets

(11) Veröffentlichungsnummer: **0 159 601**
**A2**

(12) # EUROPÄISCHE PATENTANMELDUNG

(21) Anmeldenummer: **85104166.5**

(22) Anmeldetag: **04.04.85**

(51) Int. Cl.$^4$: **H 01 L 29/60**, H 01 L 27/10, H 01 L 21/263, H 03 K 19/094, H 03 F 3/195

(30) Priorität: **10.04.84 AT 1194/84**

(43) Veröffentlichungstag der Anmeldung: **30.10.85 Patentblatt 85/44**

(84) Benannte Vertragsstaaten: **AT DE FR GB IT**

(71) Anmelder: **Thim, Hartwig Wolfgang Prof.Dr., Wolfauerstrasse 10, A-4040 Linz (AT)**

(72) Erfinder: **Thim, Hartwig Wolfgang Prof.Dr., Wolfauerstrasse 10, A-4040 Linz (AT)**

(74) Vertreter: **Mehl, Ernst, Dipl.-Ing. et al, Postfach 22 01 76, D-8000 München 22 (DE)**

(54) **Logik-Schaltungsanordnung mit dazu angepasst ausgebildeten Feldeffekt-Transistoren.**

(57) Logik-Schaltungsanordnung (Fig. 1) mit direkter Kopplung von Drain (4) und Gate (8) zweier aufeinanderfolgender Stufen. Wenigstens einer der FET's hat eine vergrabene Elektrodenschicht (6) mit angrenzenden, nicht-durchtunnelbaren Isolationsschichten (5, 7). Die Elektrodenschicht (6) ist durch Einstrahlung von außen elektrisch aufgeladen, so daß die Zone der Länge $L_g$ Normally-off-Eigenschaft hat.

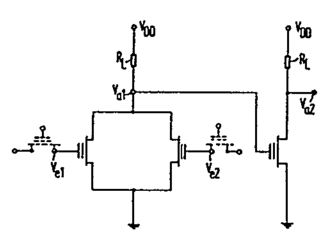

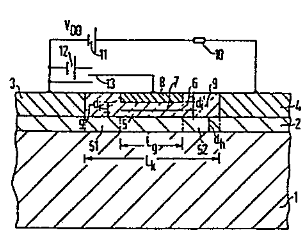

EP 0 159 601 A2

Prof. Dr. Hartwig Wolfgang Thim
Wolfauerstraße 10
A - 4040 L i n z

Unser Zeichen
VPA 84 P 8067 E

Logik-Schaltungsanordnung mit dazu angepaßt ausgebildeten Feldeffekt-Transistoren

Die Erfindung bezieht sich auf eine Logik-Schaltungsanordnung mit den Merkmalen des Oberbegriffes des Patentanspruches 1.

Für digitale und analoge Datenverarbeitung werden Logik-Schaltungsanordnungen verwendet, an die eine Vielzahl Anforderungen gestellt werden. Zum einen soll eine solche Logikschaltung mit hoher Packungsdichte, d.h. für hochintegrierte Schaltungen (VLSI) zu realisieren sein. Eine solche Schaltung soll hohe Verarbeitungsgeschwindigkeit besitzen. Man verwendet für solche Schaltungen Transistoren der Silizium-Bipolar-Technologie, der Silizium-MOS-Technologie und/oder Transistoren aus Verbindungs-Halbleitermaterial, wie z.B. MESFET- und/oder MISFET-Bauelemente.

Außer der bereits erwähnten Packungsdichte und geforderten hohen Schaltzeit werden weitere Forderungen gestellt, nämlich hohe Treiberstärke, geringe Verlustleistung, hoher Störabstand und/oder geringe Unterschiede des Wertes der Schwellenspannung für eine Vielzahl auf einem Chip integrierter derartiger Bauelemente. Speziell für analoge Schaltungen spielen auch die Ausgangsleistung, das Verhältnis zwischen Radiofrequenz(RF)-Leistung und Strom-(DC-)Verbrauch und die Rauschzahl eine Rolle.

Figur 1 zeigt als Beispiel für eine hier in Frage kommende (an sich bekannte) Schaltung eine solche mit einem

NOR-Gatter und einer nachfolgenden Inverterstufe. Betrieben wird diese Schaltung mit einer Versorgungsspannung $V_{DD}$. Gewünscht ist, daß eine solche Schaltung sowohl hinsichtlich der Versorgungsspannung als auch der für die Elemente vorzusehenden Ansteuerspannungen mit elektrischer Spannung nur einer einzigen Polarität zu betreiben ist.

Für die vorliegende Erfindung relevant sind Feldeffekt-Transistoren des Normally-off-Typs, d.h. des Anreicherungstyps, die ohne Gate-Spannung nicht leitend sind. Durch Anlegen positiver Gate-Spannungen $V_{e1}$, $V_{e2}$ werden diese Transistoren leitend geschaltet bzw. durch das entsprechende Absenken des Potentials $V_{a1}$ wird der Transistor der Inverterstufe sperrend.

Als Normally-off-Feldeffekt-Transistoren stehen verschiedene derartige Typen zur Verfügung.

Bekannt ist ein Galliumarsenid-Feldeffekt-Transistor mit einer extrem dünnen, aktiven Galliumarsenidschicht (Dicke ca. 50 nm). Näheres hierzu geht aus "1979 GaAs IC Symposium, Lake Tahoe, Sept. 1979" hervor. Ein solcher Feldeffekt-Transistor ist ohne anliegende Gate-Spannung sperrend und wird mit Gate-Spannung leitend. Probleme mit derartigen Feldeffekt-Transistoren ergeben sich im Zusammenhang mit der Integration, weil nämlich über eine größere Chipfläche hinweg derartige geringe Dicke der aktiven Schicht schwierig in den Grenzen einzuhalten ist, die hinsichtlich noch tolerierbarer Schwankungen des Schwellenspannungswertes hinnehmbar sind. Ein weiterer Nachteil ist der bei kleinen Betriebsspannungen ungünstige Arbeitsbereich im nicht gesättigten Teil des Kennlinienfeldes, wodurch die für eine erfindungsgemäße Schaltung erwünschte Steilheit und hohe Schaltgeschwindigkeit hier nicht zu erreichen wäre.

Bekannt sind auch Junction-Feldeffekt-Transistoren, die anstelle des erwähnten Schottky-Gates eine pn-Diode besitzen und deren logischer Spannungshub um einige Zehntel Volt erhöht ist. Hohe Randkapazität des p-Bereiches führt jedoch zu starken Schaltverzögerungen.

Bekannt sind auch Isolationsgate-Feldeffekt-Transistoren (MISFET), deren dünne isolierende Schicht unterhalb des Schottky-Gate dazu dient, die hohen Durchlaßströme eines Schottky-Feldeffekt-Transistors, die bei positiver angelegter Gate-Spannung auftreten, zu vermeiden. Nicht exakt eingehaltene Dicke der isolierenden Schicht ergibt zu große Schwankungen des Schwellenspannungswertes.

Ein weiterer bekannter Feldeffekt-Transistor des Normally-off-Typs ist der HEMT-Transistor mit einer sehr dünnen (50 nm) Schicht aus hochdotiertem Gallium-Aluminium-Arsenid unterhalb des Schottky-Gate und mit absichtlich undotierter, aktiver Galliumarsenidschicht.

Eine Logikschaltung mit direkter Kopplung aufeinanderfolgender Transistoren, z.B. nach Figur 1, mit Normally-off-Transistoren der obengenannten Typen zu realisieren, führt zu bereits aufgezeigten Problemen.

Der Vollständigkeit halber sei noch auf Logikschaltungen mit Normally-on-Feldeffekt-Transistoren hingewiesen. Insbesondere gehören hierzu Verarmungs-MESFET-Feldeffekt-Transistoren. Diese haben eine beispielsweise 150 nm

dicke aktive Schicht aus beispielsweise Galliumarsenid auf elektrisch isolierendem Substrat, z.B. aus bevorzugt semiisolierendem Galliumarsenid. Infolge der größeren Schichtdicke weisen solche Transistoren in integrierten Schaltungen untereinander relativ geringe Unterschiede hinsichtlich des Schwellenspannungswertes auf. Sie haben auch relativ kurze Schaltzeit und hohe Störsicherheit. Ihr wesentlicher Nachteil ist aber, daß sie eine der Versorgungsspannung $V_{DD}$ entgegengesetzte Gate-Spannung erfordern, um nichtleitend geschaltet zu werden. Dies bedingt eine zusätzliche Spannungsversorgung. Dadurch entstehen auch zusätzliche Schaltverzögerungen und Verlustleistung.

Aufgabe der vorliegenden Erfindung ist es, solche Maßnahmen anzugeben, mit denen eine Logik-Schaltungsanordnung zu realisieren ist, die die Vorteile bekannter Technologien aufweist, jedoch frei von deren Nachteilen ist. Insbesondere soll die Schaltungsanordnung nach der Erfindung derart sein, daß sie bei einerseits möglichst geringem technologischen Herstellungsaufwand andererseits hohe Schaltgeschwindigkeit, geringe Verlustleistung, hohe Treiberstärke besitzt, und die keine weitere Spannungsquelle erforderlich macht. Für den großintegrierten Aufbau auf einem Chip soll die Schwankung der Werte der Schwellenspannung bei vertretbarem technologischem Aufwand möglichst klein sein.

Diese Aufgabe wird mit einer Schaltungsanordnung mit den Merkmalen des Patentanspruches 1 gelöst und weitere Ausgestaltungen gehen aus den Unteransprüchen hervor.

Im Rahmen der Überlegungen, die zu der vorliegenden Erfindung geführt haben, ergab sich, daß für eine die gestellte Aufgabe lösende Lehre zum technischen Handeln zweckmäßigerweise doch von einem Feldeffekt-Transistor des Verarmungstyps (normally-on) ausgegangen werden sollte, obwohl bereits zahlreiche, jedoch noch unbefriedigende einschlägige Lösungswege bekannt sind, für die stets von Feldeffekt-Transistoren des Anreicherungstyps (normally off) ausgegangen worden ist.

Für die vorliegende Erfindung ist ein für eine logische Schaltungsanordnung angepaßter Feldeffekt-Transistor entwickelt worden, dessen Einzelheiten nachfolgend näher beschrieben sind.

Der bei der Erfindung verwendete Feldeffekt-Transistor hat zu einem Anteil Merkmale seines Aufbaues, die an sich von Feldeffekt-Transistoren verschiedener Typen her prinzipiell bekannt sind. Hinsichtlich des Substrats, der auf dem Substrat befindlichen aktiven Halbleiterschicht, des Source-Gebietes und -Kontaktes, des Drain-Gebietes und -Kontaktes sowie bezüglich der Gate-Elektrode kann auf allgemeine Kenntnis über Feldeffekt-Transistoren hingewiesen werden. Bei der Erfindung hat der Feldeffekt-Transistor zwischen der aktiven Halbleiterschicht und der Gate-Elektrode Isolatormaterial, in das parallel zur Ausdehnung der Gate-Elektrode bzw. der aktiven Halbleiterschicht eine Haftstellenschicht in der Ausführung einer elektrisch leitenden Elektrodenschicht eingebettet ist. An sich ist die Verwendung einer solchen und derart angeordneten Elektrodenschicht z.B. als Floating-Gate bekannt. Zum Beispiel geht aus der DE-OS 30 32 306 bzw. der US-PS 4 441 036 ein als Feldeffekt-Transistor anzusprechender Halbleiteraufbau hervor, der im Inneren einer Isolatorschicht unterhalb einer Gate-Elektrode eine zu dieser parallele Polysiliziumschicht hat. Diese Schicht hat ebenfalls keinen nach außen gehenden Kontakt. Dieser aus der genannten DE-OS bzw. US-PS bekannte Feldeffekt-Transistor ist dazu vorgesehen, ein fuseable

link in einer Schaltung mit redundanten Schaltungselementen bzw. Schaltungsgruppen zu ersetzen. Durch Aufladung dieser Elektrodenschicht aus Polysilizium mittels von außen eingeprägter Elektronenstrahlung läßt sich dieses bekannte Schaltelement bei der Herstellung der Schaltungsanordnung, in der es verwendet ist, so verändern, daß es nachfolgend dauernd leitend oder dauernd sperrend ist, d.h. mit einem Schaltungsteil eine dauernde elektrische Verbindung bewirkt bzw. eine dauernde Unterbrechung aufrechthält.

Lediglich der Vollständigkeit halber sei auf MNOS-Feldeffekt-Transistoren hingewiesen, die als insbesondere programmierbare Speicherelemente verwendet werden. Sie können zwischen der Oxid- und der Nitridschicht eine nach außen nicht anzuschließende Elektrode haben. Die Einstellung bzw. Änderung des jeweiligen Speicherzustandes erfolgt durch Anlegen von Überspannungen und durch Tunnelstrom von Ladungsträgern durch die Oxid- und/oder Nitridschicht, wozu diese nur geringe Dicke, z.B. kleiner als 10 nm, haben.

Anders als bei diesem Stand der Technik ist bei der Erfindung vorgesehen, bei der Herstellung der erfindungsgemäßen Schaltungsanordnung, d.h. der in ihr erfindungsgemäß vorgesehenen Feldeffekt-Transistoren mit den bereits angegebenen Merkmalen, eine solche Aufladung dieser Haftstellen- bzw. Elektrodenschicht vorzunehmen, daß dieser Feldeffekt-Transistor, des Normally-on-Typs als ein solcher des Normally-off-Typs wirksam wird. Dieser ist durch die betriebsübliche Ansteuerung seines Gates bzw. der Gate-Elektrode aus dem (bei fehlender Gate-Spannung) sperrenden Zustand in den (bei anliegender Gate-Spannung) leitenden Zustand gesteuert werden kann, wobei dies beliebig reversibel durchführbar ist.

Gemäß einer Ausführung zur vorliegenden Erfindung wird mit

Hilfe einer Elektronenbestrahlung diese Haftstellen- bzw. Elektrodenschicht dauerhaft flächenspezifisch (gleich oder höher als der) der nachfolgenden Bedingung (1) entsprechend aufgeladen:

$$Q_{HSS} \cong \frac{\varepsilon_i \, e \, N_D}{2 \, \varepsilon_h \, d_i'} \left( d_h^2 + 2 \, d_h \, d_i \frac{\varepsilon_h}{\varepsilon_i} - \frac{2 \, \Psi_{mh} \varepsilon_h}{e^2 \, N_D} \right) \left[ Cb/cm^2 \right] \qquad (1)$$

In dieser Gleichung bedeuten: $\varepsilon_h$ die Dielektrizitätskonstante des Halbleitermaterials der aktiven Schicht,
$\varepsilon_i$ die Dielektrizitätskonstante des die Haftstellen- bzw. Elektrodenschicht umgebenden Isolatormaterials,
$d_i$ den Abstand der Gate-Elektrode von der Oberfläche der aktiven Halbleiterschicht,
$d_i'$ den Abstand der Elektrodenschicht von der Gate-Elektrode (die Dicke der Elektrodenschicht ist vernachlässigbar),
$d_h$ die Dicke der aktiven Halbleiterschicht,
$N_D$ die Dotierung der aktiven Halbleiterschicht mit Donatoren für n-leitenden (bzw. Akzeptoren für p-leitenden) Transistor,
w die Breite des Source/Drain-Kontaktes,
$\Psi_{mh}$ die Differenz der Austrittsarbeit (in Volt) zwischen dem Metall der Gate-Elektrode und dem Halbleitermaterial).

Die aufzubringende Ladung $Q_{HSS}$ ($Cb/cm^2$) auf der Elektrodenschicht ist für n-leitende Transistoren negativ und für p-leitende Transistoren positiv. (Etwas) höhere Aufladung, insbesondere 10 bis 20% höhere Aufladung, ergibt (zwar) höhere Schwellenspannung mit entsprechend höherer Störsicherheit.

Bei Erfüllung der Bedingung (1) reicht die von der Aufladung der Haftstellen- bzw. Elektrodenschicht ausgehende elektrische Feldstärke bei einer Gate-Spannung $V_{GS} = 0$ gerade aus, die unter der Gate-Elektrode in der aktiven Halbleiterschicht vorhandenen beweglichen Ladungsträger auszuräumen, deren Dichte N gegeben ist durch Gleichung (2):

$$N = N_D \, w \, L_g \left( d_h + \frac{\varepsilon_h}{\varepsilon_i} d_i - \sqrt{\frac{\varepsilon_h^2}{\varepsilon_i^2} d_i^2 + \frac{2 \varepsilon_h \psi_{mh}}{e^2 \, N_D}} \right) \qquad (2)$$

In dieser Gleichung ist $L_g$ die Länge, über die sich die die (Haftstellen-)Elektrodenschicht zwischen dem Source-Bereich und dem Drain-Bereich (mit deren Abstand $L_K$) des erfindungsgemäßen Transistors erstreckt. Mit e ist die Elementarladung bezeichnet. Vorzugsweise wählt man den Abstand $d_i^{!}$ gleich der Hälfte des Abstandes $d_i$, d.h. man ordnet die Elektrodenschicht wenigstens angenähert in der Mitte zwischen der Oberfläche der aktiven Halbleiterschicht und der Gate-Elektrode an.

Ein Ausführungsbeispiel für einen Aufbau eines bei der Erfindung zu verwendenden Transistors zeigt die Figur 2. Mit 1 ist das Substrat aus isolierendem, semi-isolierendem oder komplementär zur darauf befindlichen aktiven Halbleiterschicht 2 dotiertem Material bezeichnet, wobei das Substratmaterial vorzugsweise Halbleitermaterial ist. Es sind ein Source-Kontakt 3 und ein Drain-Kontakt 4 vorgesehen, die beim dargestellten Beispiel auf der Oberfläche der aktiven Halbleiterschicht 2 angeordnet sind. Es sind nicht sperrende Kontakte. Zwischen den dargestellten Source- und Drain-Kontakten 3 und 4 erstreckt sich über die Länge $L_g$ die Gate-Elektrode 8 als Steuerelektrode des Transistors. Gemäß einer Ausführungsvariante ist diese Gate-Elektrode 8 in das Material einer Isolatorschicht eingebettet. Diese Isolatorschicht besteht aus den mit 5, 7 und 9 bezeichneten Anteilen. Sie enthält die Haftstellen- bzw. Elektrodenschicht 6. Diese Elektrodenschicht 6 mit vorzugsweise der gleichen Länge $L_g$ ist durch den die Isolierschicht 5 bildenden Anteil gegenüber der Oberfläche der aktiven Schicht 2 elektrisch isoliert. Der die Isolierschicht 7 bildende Anteil isoliert die Elektrodenschicht 6 gegenüber der Gate-Elektrode 8. Es sind die die Schichtdicken ergebenden Abstände mit $d_i$ und $d_i'$ dargestellt.

Vorzugsweise sind die Gate-Elektrode 8 und die Elektrodenschicht 6 sich deckend bemessen und angeordnet. Die Elektrodenschicht 6 darf aber auch (etwas) kürzer und/oder (etwas) schmäler sein, ist aber von der Gate-Elektrode 8 überdeckt zu plazieren.

Mit 10 ist ein Lastwiderstand, mit 11 die Versorgungsspannungsquelle und mit 12 die Steuerspannung bezeichnet, wobei letztere über den symbolisch dargestellten Schalter 13 an die Gate-Elektrode 8 anzulegen ist.

Eine wichtige Besonderheit der Erfindung besteht darin, z.B. gegenüber der MOS-Technologie, daß hier die Gate-Elektrode die Source/Drain-Bereiche nicht erreichen und erst recht nicht überlappen muß. Solches ist nämlich für MOS-Feldeffekt-Transistoren bekannt, bei denen zur galvanischen Trennung zwischen Gate-Elektrode einerseits und den Source/Drain-Bereichen andererseits eine dünne Oxidschicht vorgesehen ist. Da bei der Erfindung ein entsprechender Abstand vorgesehen sein kann, sind die Feldoxidbereiche 9 möglich, die sichere Isolation für die entsprechenden angrenzenden Elektroden gewährleisten. Daß diese Besonderheit der Erfindung überhaupt möglich ist, liegt daran, daß der eine oder die mehreren bei einer erfindungsgemäßen Schaltungsanordnung verwendeten Transistoren mit erzwungener Normally-off-Eigenschaft diese nur in dem Bereich (über die Länge $L_g$) aufweist, die gleich der entsprechenden Ausdehnung der Haftstellen- bzw. Elektrodenschicht 6 ist.Aufgrund des verwendeten Transistors hat dieser nämlich zwischen dem Source-Kontakt bzw. -Bereich und dem benachbarten Rand der Haftstellen-bzw. Elektrodenschicht 6, d.h. in der Zone 51 Normally-on-Charakter. Entsprechendes gilt für die Zone 52. Bei der vorliegenden Erfindung ist das sonst bestehende Problem der Justierung von Gate-Elektrode und Source/Drain-Bereichen zueinander vorteilhafterweise gar nicht existent. Ebenso tritt keine nennenswerte Kapazität zu Source und Drain auf.

Es empfiehlt sich den (in der Figur 2 seitlichen) Abstand zwischen der Elektrodenschicht 6 einerseits und Source/Drain-Bereich 3/4 andererseits etwa wenigstens gleich groß wie oder größer als die Schichtdicke $d_i$, nämlich dem Isolationsabstand zwischen Elektrodenschicht 6 und Gate-Elektrode 8 bzw. Halbleiterschicht 2, zu wählen.

Es ist wichtig, hinsichtlich der Erfindung zu erwähnen, daß bei der Erfindung für die Dicke der Halbleiterschicht 2, z.B. im Gegensatz zu obengenanntem Stand der Technik, eine technologisch unkritische Bemessung von z.B. 150 nm mit einer Dotierung von z.B. $10^{17}$ $cm^{-3}$ gewählt werden kann, wie dies für MES-Feldeffekt-Transistoren des jedoch entgegengesetzten Typs (Verarmungstyp) üblich ist. Auch die Schichten 5 und 7 haben gut beherrschbar große Dicke (größer/gleich 50 nm).

Mit der Erfindung läßt sich eine direkt gekoppelte Logik-Schaltungsanordnung realisieren, die mit nur einer Versorgungsspannung $V_{DD}$ auskommt und deren Schwankungen der Schwellenspannungen einzelner Transistoren nach der Erfindung vernachläßigbar klein ist.

Die Herstellung eines bei der Erfindung verwendeten Feldeffekt-Transistors erfolgt nach an sich prinzipiell bekannten Verfahrensschritten und mit üblicherweise verwendeten Materialien. Das Halbleitermaterial der Schicht 2 kann z.B. Silizium sein. Geeignet sind auch Indiumphosphid, Galliumarsenid, Gallium-Indiumarsenid usw.. Insbesondere Verbindungshalbleitermaterial ist für die Erfindung von Interesse. Die z.B. implantierte Dotierung der aktiven Halbleiterschicht 2 kann z.B. $N_D = 10^{17}$ $cm^{-3}$ betragen. Drain/Source-Kontakte können $N^+$-Bereiche mit darauf befindlicher Kontakt-Metallisierung sein. Als Elektrodenschicht 6 wird beispielsweise eine 5 nm dicke Metall- oder Halbleiterschicht vorgesehen, die z.B. 500 nm lang und 10 µm breit bemessen ist. Die Dicke $d_i$ der Isolatorschicht 7 (und der Schicht 5) ist z.B. 50 nm und sie besteht aus beispielsweise Siliziumdioxid, Siliziumnitrid, Aluminiumoxid oder dgl.. Entsprechendes Material wird für das Feldoxid 9 verwendet. Das Aufladen der Haftstellen- bzw. Elektrodenschicht 6 erfolgt mit Maskierung z.B. einer Fotolackschicht. Entsprechendes gilt für die Gate-Elektrode 8. Außerdem werden in an sich bekannter Weise die Drain- Gate- und Source-Bereiche (der Transistoren der Schaltungsanordnung) verbindende Leiterbahnen auf die Oberfläche aufgebracht.

Ein mit der Erfindung erzielter Vorteil besteht darin, daß bei Steuergate-Spannung $V_{GS} = 0$ unter der Gate-Elektrode in

der aktiven Halbleiterschicht 2 keine beweglichen Ladungsträger vorhanden sind. Der Transistor weist trotz der für Normally-on-Verhalten üblichen Halbleiterschichtdicke $d_h$ (beispielsweise 150 nm für $N_d = 10^{17}\ cm^{-3}$) Normally-off-Verhalten auf, so daß eine direkte Ankopplung an vor- und nachgeschaltete Stufen ohne zusätzlichen Schaltungsaufwand und mit nur einer Versorgungsspannung $V_{DD}$ erfolgen kann. Ein weiterer Vorteil ist, daß bei der Erfindung über eine große Chipfläche eine solche Gleichmäßigkeit der aktiven Schicht 2 eingehalten werden kann, die nur noch kleine Schwankungen des Wertes der Schwellenspannung zur Folge hat. Ein weiterer wichtiger Vorteil besteht in der Möglichkeit, durch Verwendung eines komplementären Transistors als Lastwiderstand (siehe auch die noch zu beschreibende Figur 3) dessen Gate-Elektrode an den des Schalttransistors anzuschließen und so eine extrem schnelle und verlustleistungsarme Komplementärlogik aufzubauen, die hinsichtlich der Schaltgeschwindigkeit einer bekannten CMOS-Logikschaltung überlegen ist, und zwar wegen der bei der Erfindung ohne weiteres vermeidbaren Gate-Überlappung und des bei der Erfindung fehlenden Drain/Source-Durchbruchseffekts (punchthrough).

Weitere Vorteile sind die kleinen Source- und Drain-Widerstände, die für Normally-on-MES-Feldeffekt-Transistoren typischen kurzen Schaltzeiten, die aus der direkten Ankopplung resultierende kleine Gate-Verlustleistung, die für VLSI-Schaltungen erforderliche, günstigerweise hohe Packungsdichte und die für hohe Störsicherheit wichtigen kleinen Schwankungen der Schwellenspannung.

Ein weiterer Vorteil liegt darin, daß sich der Ladungsträgertransport nicht wie bei den anderen Normally-off-Transistoren (Anreicherungs- und Inversionstypen) an der

Isolator-Halbleitergrenzfläche, an der wegen der Grenzflächenrauhigkeit die Beweglichkeit reduziert ist, sondern im ungestörten Halbleitervolumen abspielt. Allerdings soll auch in der neuen Logik die Dichte der Energiezustände in der Energielücke an der Isolator/Halbleitergrenzfläche klein gehalten werden, damit etwaige in diesen Zuständen sitzende Ladungsträger kein "Ferminiveaupinning" hervorrufen. Diese Bedingung läßt sich durch besonders reinliche Herstellungsprozeßführung erfüllen, wie es bereits für Silizium MOSFETs und GaInAs, InP und GaAs-MISFETs gezeigt worden ist. Erreicht jedoch die Zwischenschichtszustandsdichte einen der Ladung $Q_{HSS}$ vergleichbaren Wert, muß die nach Gleichung (1) berechnete Ladung um den Wert der Zwischenschichtszustandsdichte erhöht werden.

Die Figuren 3 und 4 zeigen weitere Beispiele für Schaltungsanordnungen nach der Erfindung. Figur 3 ist eine bereits erwähnte Komplementärschaltung mit einer Wanne 14, die dem umgebenden Substratmaterial 1 gegenüber entgegengesetzten Leitungstyp hat. Die in Figur 3 verwendeten Bezugszeichen haben die zur Figur 2 angegebenen Bedeutungen. Die mit dem Zusatz a versehenen Bezugszeichen haben die entsprechende Bedeutung, sind jedoch auf den in der Wanne 14 ausgeführten komplementären Transistor bezogen. Eine Ausführungsform nach Figur 3 ist insbesondere in Siliziumtechnologie zu realisieren. Auch in dieser erfindungsgemäßen Realisierung einer Komplementärschaltung fließt, vom Umschaltstrom abgesehen, praktisch kein Strom.

Figur 4 zeigt einen Mikrowellenverstärker. In dieser Schaltung wird das zu verstärkende Signal 15 über den Kondensator 16, der die Gate-Vorspannung 12 abblockt, an das Gate 8 gelegt. Die Induktivität 17 führt die Gate-Vorspannung 12 an das Gate 8 und hält das Signal des Signalgenerators 15 von

der Batterie 12 fern. Das verstärkte Signal wird vom Drain 4 über den Kondensator 18 an die Lastimpedanz 19 geführt. Die Drain-Gleichspannung 11 wird über die Induktivität 20 dem Drain-Kontakt 4 zugeführt. Der Vorteil dieser Schaltung liegt in seiner Einfachheit wegen der gleichen Polaritäten der Batterien 11 und 12, die durch eine einzige Versorgungsspannung ersetzt werden können. Dies begünstigt monolithische Integration ("MIC") und erhöht die Grenzfrequenz gegenüber Normally-on-MESFET-Schaltungen. Die übrigen Bezugszeichen entsprechen denen der Figur 2. Diese Schaltung arbeitet als Analogverstärker oder mit einer zusätzlich vorzusehenden Rückkopplung als selbstschwingender Oszillator (wobei der Signalgenerator 15 entfallen kann).

5 Patentansprüche

4 Figuren

Patentansprüche

1. Logik-Schaltungsanordnung,
geeignet für kurze Schaltzeiten, für Großintegration mit hoher Packungsdichte und für eine Stromversorgung mit nur einer Polarität der Versorgungsspannung

- mit Feldeffekt-Transistoren mit einer aktiven Halbleiterzone (2), mit Source-Gebiet (3), Drain-Gebiet (4), Kanalbereich, Gate-Elektrode (8) und Gate-Isolation (5, 7) und
- mit in dieser Schaltungsanordnung direkter Kopplung vom Drain eines Feldeffekt-Transistors der einen Stufe zum Gate eines Feldeffekt-Transistors der folgenden Stufe,

g e k e n n z e i c h n e t dadurch,

- daß wenigstens einer der Transistoren einen solchen Aufbau (Fig. 2) hat,
- der eine in anderem Zusammenhang an sich bekannte Elektrodenschicht (6) aufweist, die innerhalb der Gate-Isolation (5, 7) vergraben unterhalb der Gate-Elektrode (8) angeordnet ist,
- bei dem die diese Gate-Elektrode (8) und diese Elektrodenschicht (6) voneinander trennende Isolatorschicht (7) und die die aktive Halbleiterzone (2) und diese Elektrodenschicht (6) voneinander trennende Isolatorschicht (5) beide eine solche Dicke ($d_i'$, $d_i-d_i'$) haben, daß diese Isolatorschichten (7, 5) bei normalem Betrieb der Schaltungsanordnung (Fig. 1) von Ladungsträgern nicht durchtunnelbar sind,
- daß zwischen Source (3) und der vergrabenen Elektrodenschicht (6) und daß zwischen Drain (4) und der vergrabenen Elektrodenschicht (6) je ein isolierender Schutzabstand (9) vorgesehen ist, so daß dort in der aktiven Halbleiterzone (2) von Potentialen der vergrabenen Elektrodenschicht (6) im wesentlichen unbeeinflußte Zonen (51, 52) vorliegen und

- daß die vergrabene Elektrodenschicht (6) eine flächenspezifische elektrische Aufladung aufweist, die gleich oder höher ist als der Gleichung (1)

$$Q_{HSS} \cong \frac{\varepsilon_i \; e \; N_D}{2 \; \varepsilon_h \; d_i'} \left( d_h^2 + 2 \, d_h \, d_i \frac{\varepsilon_h}{\varepsilon_i} - \frac{2 \Psi_{mh} \varepsilon_h}{e^2 \; N_D} \right) \left[ Cb/cm^2 \right]$$

entsprechend bemessen ist.

2. Schaltungsanordnung nach Anspruch 1, g e k e n n z e i c h n e t dadurch, daß für höhere Störsicherheit diese Aufladung der vergrabenen Elektrodenschicht (6) etwa 10 bis 20% höher als der Gleichung (1) entsprechend bemessen ist.

3. Schaltungsanordnung , g e k e n n z e i c h n e t dadurch, daß zu einem Transistor nach Anspruch 1 oder 2 ein komplementärer Transistor (Fig. 3) mit sonst gleichem Aufbau vorgesehen ist, der die entsprechende komplementäre Aufladung hat.

4. Schaltungsanordnung nach Anspruch 1, 2 oder 3, g e k e n n z e i c h n e t dadurch, daß das Material der aktiven Halbleiterzone (2, 2') III-V-Verbindungs-Halbleitermaterial ist.

5. Schaltungsanordnung nach Anspruch 1, 2, 3 oder 4, g e k e n n z e i c h n e t dadurch, daß die Aufladung durch Elektronenbestrahlung bewirkt ist.

0159601

1/2

FIG1

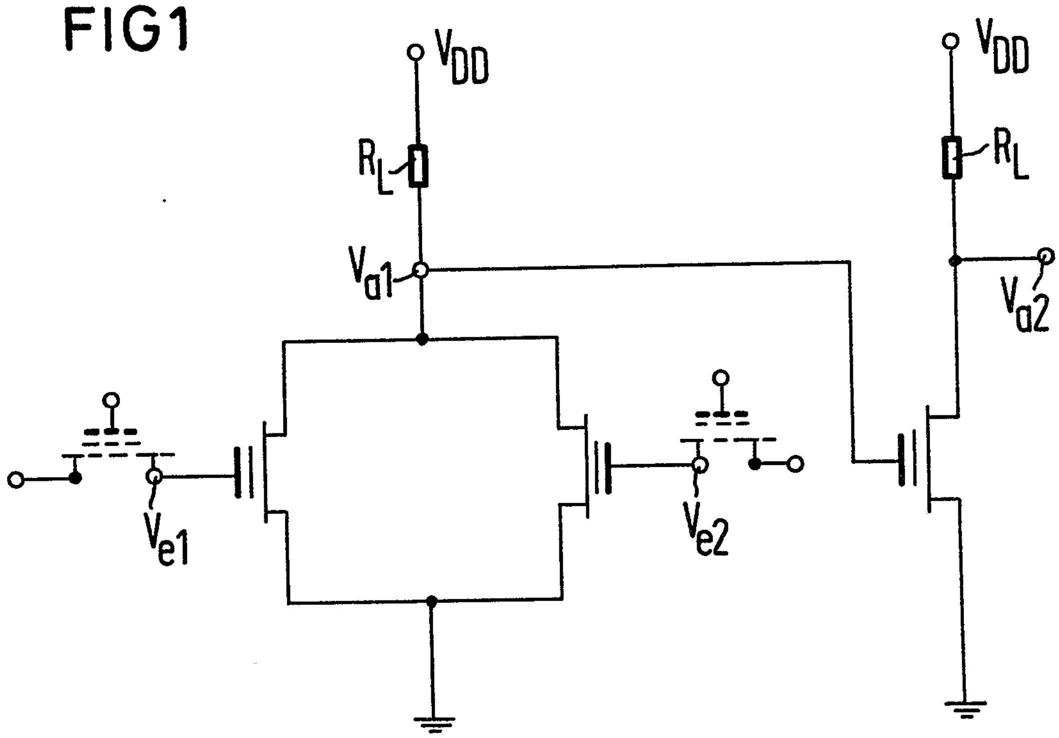


FIG 2

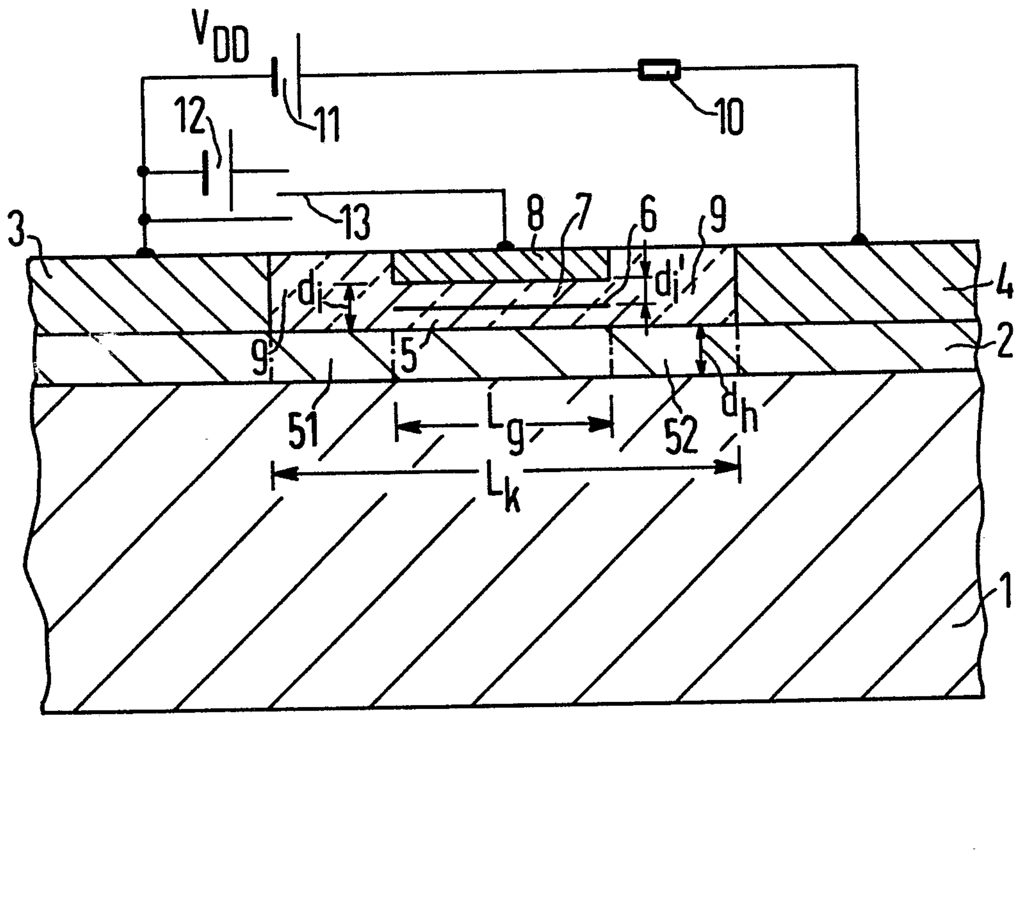

FIG 3

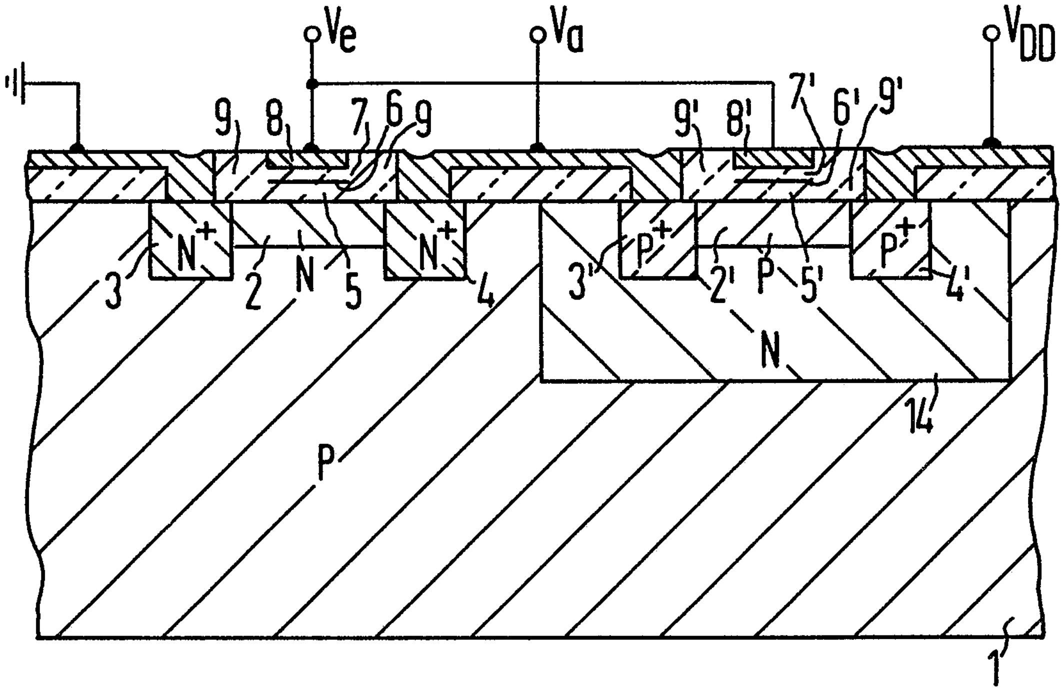
Ve
Va
VDD
9
8
7
6
9
9'
8'
7'
6'
9'
N+
N
N+
P+
P
P+
3
2
5
4
3'
2'
5'
4'
N
14
P
1

FIG 4

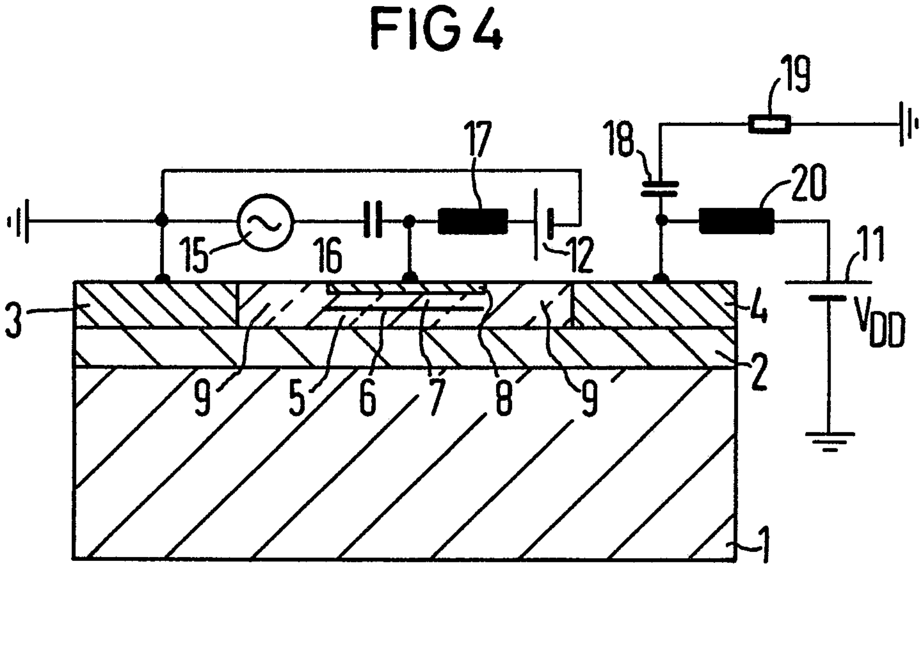
19
18
17
20
11
15
16
12
VDD
3
4
2
9
5
6
7
8
9
1